# EUROPEAN PATENT APPLICATION

(11) **EP 3 660 548 A1**
(43) Date of publication of application: **03.06.2020**
(21) Application number: 19207675.0
(22) Date of filing: 07.11.2019
(51) Int. Cl.: G02B 1/115, G02B 1/14, C23C 14/00, G02B 1/18

(54) **OPTICAL MEMBER AND PRODUCING METHOD OF OPTICAL MEMBER**

(30) Priority: 26.11.2018 JP 2018219874
(71) Applicant: KONICA MINOLTA, INC., Tokyo 100-7015 (JP)
(72) Inventor: Nose, Masaaki, Tokyo, 100-7015 (JP)
(74) Representative: Hoffmann Eitle

(57) **Abstract**

Disclosed is an optical member including dielectric multilayer films on a substrate, wherein an immediately lower layer of an uppermost layer is a layer containing any one of SiO₂, MgF₂ and Al₂O₃, or a mixture of any combination of SiO₂, MgF₂ and Al₂O₃; and the uppermost layer is a metal oxide layer containing SiO₂ as a main component and also containing at least one of Cr and Ti.

## Description

Japanese Patent Application No. 2018-219874, filed on November 26, 2018 with Japan Patent Office, is incorporated herein by reference in its entirety.

### Background

### 1. Technological Field

The present invention relates to an optical member and a method of producing the optical member. More specifically, the present invention relates to an optical member having excellent salt water resistance, which is free from the influence of environmental deterioration on the spectral reflectance of the lower layer and the occurrence of ghosts and flares associated therewith by improving the removability by salt water of the uppermost layer which contains SiO₂ as a main component.

### 2. Description of the Related Art

In order to support driving of a vehicle, a vehicle is equipped with an on-vehicle camera. More specifically, a camera for capturing the back and side of a vehicle is mounted on the vehicle body of an automobile, and the image captured by this camera is displayed at a position visible to the driver to reduce the blind spot, thereby it can contribute to safe driving.

Incidentally, the on-vehicle camera is often mounted outside the vehicle, and the lens used has a strict requirement for guaranteeing the environmental resistance. For example, in a salt spray test on a lens, when the light reflectance changes due to the dissolution of SiO₂ which is a component of the anti-reflection film on the lens surface into salt water, it causes ghosts and flares.

Therefore, it is preferable to use a low refractive index material as a main component in the uppermost layer of the lens, and to form a protective film having a small influence on the light reflectance of the lower layer. It is desirable that the film thickness is as thin as possible because the light reflectance of the antireflective film changes if the protective film is a relatively thick protective film having a film thickness of 20 nm or more. If possible, it is desirable to form a protective film having a thickness of 15 nm or less, preferably 10 nm or less.

As a thin film optical element having dielectric multilayer films, a technique is disclosed in which a plurality of Al₂O₃ containing layers and a plurality of SiO₂ containing layers are alternately laminated, and a layer containing SiO₂ is further laminated as an uppermost layer (for example, refer to Patent Document 1: JP-A 2001-074931).

However, when the uppermost layer is simply a layer containing SiO₂, the spectral reflectance changes due to the dissolution of the SiO₂ on the surface in salt water in the salt spray test. This causes ghosts and flares, and the problem is not solved.

On the other hand, from the viewpoint of durability, a film formation technique using an ion assisted deposition (hereinafter also referred to simply as "IAD") method in addition to the vapor deposition method as a method for forming a dense uppermost layer is known (for example, refer to Patent Document 2: JP-A 2003-221663 and Patent Document 3: WO 2015/030015).

The IAD method is a method of forming a dense film by causing high kinetic energy of ions to act during film formation, or enhancing the adhesion between a film and a substrate. It is preferable to apply as a means to improve the durability of the uppermost layer.

However, when the deposition method using the IAD method is applied to the extremely thin layer formation required for the uppermost layer, the circumferential film thickness does not become uniform in the device. In addition, when the uppermost layer material is a mixture, there is a problem that the materials are limited to have near vapor pressure, and it is difficult to form the uppermost layer with a desired material ratio and film thickness.

Therefore, the appearance of the following optical member is awaited. That is, while the lens top layer is mainly composed of SiO₂ which is a low refractive index material, there is no change in spectral reflectance due to dissolution and peeling of the SiO₂ containing layer without occurrence of ghosts and flares in the salt spray test.

### Summary

The present invention has been made in view of the above problems and circumstances. An object of the present invention is to provide an optical member excellent in salt water resistance and a method of manufacturing the same, which is free from the influence of environmental deterioration on the spectral reflectance of the lower layer and the occurrence of ghosts and flares associated therewith accompanying the passage of time by improving the removability by salt water of the uppermost layer which contains SiO₂ as a main component.

An optical member that reflects an aspect of the present invention is an optical member comprising a plurality of antireflection layers on a substrate, wherein an immediately lower layer of an uppermost layer is a thin film containing a low reflective index material, for example, a thin film containing any of SiO₂, MgF₂, and Al₂O₃, or a mixture made of these materials (SiO₂, MgF₂, and Al₂O₃), and the uppermost layer is a metal oxide layer mainly composed of SiO₂ and containing at least a specific element.

### Brief Description of the Drawings

The advantages and features provided by one or more embodiments of the invention will become more fully understood from the detailed description given hereinbelow and the appended drawings which are given by way of illustration only, and thus are not intended as a definition of the limits of the present invention.
FIG. 1 is a graph indicating the change of the spectral reflectance by the salt spray test of a SiO₂ containing layer.
FIG. 2 is a schematic diagram indicating the configuration of an optical member of the present invention.
FIG. 3 is a schematic diagram indicating an example of an IAD vapor deposition apparatus.
FIG. 4 is a schematic diagram indicating an example of an ion beam sputtering film forming apparatus.
FIG. 5A is a schematic diagram indicating an arrangement of sputtering targets when a plurality of film forming materials are used.
FIG. 5B is a schematic diagram indicating an arrangement of sputtering targets when a plurality of film forming materials are used.
FIG. 6 is a plan view and a sectional view indicating an arrangement of specific sputtering targets in the case of two film forming materials.
FIG. 7 is a schematic view indicating an example of a film forming apparatus combining an IAD vapor deposition apparatus and an ion beam sputtering apparatus.
FIG. 8A is a graph indicating a spectral reflectance of an optical member sample.
FIG. 8B is a graph indicating a spectral reflectance of an optical member sample.
FIG. 9A is a graph indicating a spectral reflectance of an optical member sample.
FIG. 9B is a graph indicating a spectral reflectance of an optical member sample.
FIG. 10A is a graph indicating a spectral reflectance of an optical member sample.
FIG. 10B is a graph indicating a spectral reflectance of an optical member sample.
FIG. 11A is a graph indicating a spectral reflectance of an optical member sample.
FIG. 11B is a graph indicating a spectral reflectance of an optical member sample.
FIG. 12A is a schematic diagram indicating a photocatalytic effect evaluation method.
FIG. 12B is a schematic diagram indicating a photocatalytic effect evaluation method.
FIG. 12C is a schematic diagram indicating a photocatalytic effect evaluation method.

### Detailed Description of the Embodiments

Hereinafter, one or more embodiments of the present invention will be described with reference to the drawings. However, the scope of the invention is not limited to the disclosed embodiments.

The optical member of the present invention is an optical member having dielectric multilayer films on a substrate, wherein an immediately lower layer of an uppermost layer is a layer containing any one of SiO₂, MgF₂, or Al₂O₃, or a mixture of any combination comprising these materials; and the uppermost layer is a metal oxide layer containing SiO₂ as a main component and containing at least one element of Cr or Ti. This feature is a technical feature common or corresponding to the following embodiments.

According to the present invention, it is possible to provide an optical member excellent in salt water resistance and a method of manufacturing the same, which is free from the influence of environmental deterioration on the spectral reflectance of the lower layer and the occurrence of ghosts and flares associated therewith by improving the removability by salt water of the uppermost layer which contains SiO₂ as a main component.

The expression mechanism or action mechanism of the effect of the present invention is as follows.

In the configuration of the dielectric multilayer films in which a plurality of conventional Ta₂O₅/SiO₂ containing layers are alternately laminated, in order to evaluate the salt water resistance of the SiO₂ containing layer that forms the uppermost layer, a salt spray test was performed. The change in spectral reflectance when the SiO₂ containing layer was dissolved and peeled was examined.

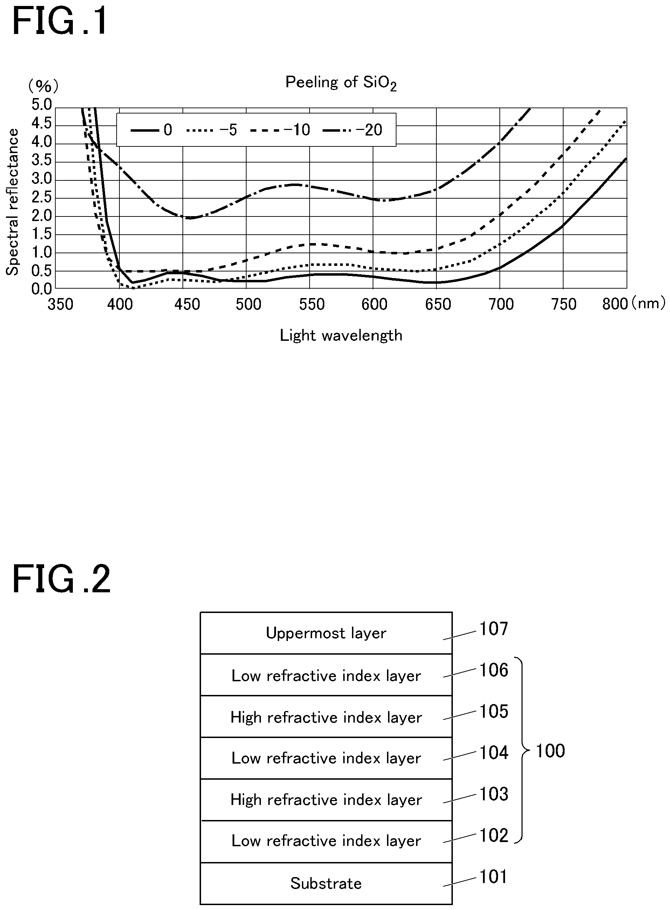

FIG. 1 is a diagram indicating a change in spectral reflectance when a SiO₂ containing layer that forms the uppermost layer is dissolved in salt water and peeled off in a salt spray test.

To dielectric multilayer films in which a plurality of Ta₂O₅/SiO₂ layers having an antireflection function are alternately laminated (substrate / Ta₂O₅ (26.4 nm) / SiO₂ (24.9 nm) / Ta₂O₅ (26.4 nm) / SiO₂ (29.4 nm) / Ta₂O₅ (130.1 nm) / SiO₂ (87.5 nm))(the figure in parentheses indicates the layer thickness), the SiO₂ containing layer that forms the uppermost layer is subjected to the following salt spray test, and then the spectral reflection characteristics are measured. The spectral reflectance can be measured in the optical wavelength region (in the range of 350 to 800 nm), for example, with a spectrophotometer U-4100 manufactured by Hitachi High Technology Co., Ltd.

### <Salt spray test>

The following steps (a) to (c) are considered as 1 cycle, and 8 cycles are carried out.
(a) The following solvent at 25 ± 2 °C is sprayed on the sample surface for 2 hours at a temperature in the spray tank of 35 ± 2 °C (saline concentration 5%).
(b) After spraying, leave the sample at 40 ± 2 °C and 95 %RH for 22 hours.
(c) After repeating (a) and (b) four times, leave the sample at 25 °C and 55 %RH for 72 hours.

### <Solvent>

### Solute used: NaCl, MgCl₂, CaCl₂

### Solute concentration: 5 ± 1% (mass ratio)

According to FIG. 1, with respect to the spectral reflectance of the sample before the salt spray test (described as 0), the SiO₂ containing layer was dissolved from the surface by 5 nm (described as -5), dissolved by 10 nm (described as -10) and dissolved by 20 nm (described as -20). It can be seen that the spectral reflectance of the sample changes significantly as it is dissolved. Due to such changes, for example, when the uppermost layer of the antireflection layer (dielectric multilayer film) on the lens is dissolved and peeled off by the external environment (salt water), it is conceivable that flare and ghost are generated and deteriorated from the original performance.

The optical member of the present invention is an optical member having a plurality of antireflection layers on a substrate, wherein a layer immediately below an uppermost layer is a layer containing either SiO₂, MgF₂, or Al₂O₃, or a mixture comprising these materials; and the uppermost layer is a metal oxide layer containing SiO₂ as a main component and containing at least one element of Cr or Ti.

In particular, it has been found that the uppermost layer contains SiO₂ as a main component and contains a specific amount of at least one of Cr and Ti, thereby improving the salt water solubility resistance of SiO₂.

The mechanism by which the salt water resistance of the SiO₂ containing layer is improved by containing any element of Cr or Ti is presumed as follows.

In the salt spray test of the SiO₂ containing layer, the pH of salt water at 25 °C is about 7 (weakly alkaline), so the Si-O bond is easily broken, and the SiO₂ containing layer gradually dissolves in salt water and peels off. Therefore, by adding any element of Cr or Ti in which the activity of oxides or hydroxides is higher than that of ions in the pH range to the SiO₂ containing layer, the bond to salt water is stabilized and solubility will decrease.

On the other hand, it is preferable that the uppermost layer according to the present invention is formed as a high-density film from the viewpoint of film formation that is thin but robust.

It is a preferable film formation method from the viewpoint of productivity that the uppermost layer according to the present invention is formed by sputtering using an ion source of an ion assisted deposition method as a sputtering source.

As described above, when the vapor deposition method using the IAD method is applied to the formation of an extremely thin layer required for the uppermost layer, the film thickness in the circumferential direction is not uniform in the apparatus. In addition, when the uppermost layer material is a mixture, there is a problem that the material is limited to a material having a near vapor pressure, and it is difficult to form the uppermost layer with a desired material ratio and film thickness, and the expected salt water resistance is not achieved.

In the present invention, by employing a method of forming a film on the dielectric multilayer films on the substrate by sputtering using the IAD ion source as a sputtering source, the uppermost layer according to the present invention can be formed at any composition ratio. In addition, a uniform and thin uppermost layer can be formed while ensuring high productivity.

Specifically, a sputtering target is disposed between the dielectric multilayer films on the substrate and the ion source, and a surface of the sputtering target opposite to a surface facing the substrate is sputtered by an ion beam. The scattering speed of the sputtered target particles to the substrate is delayed, and the film forming speed can be made slower than that of the conventional method. As a result, it is possible to form a uniform thin film with a desired material composition ratio on the substrate while being a very thin layer. For example, the uppermost layer formed in this way is an uppermost layer having excellent salt water resistance without affecting the spectral reflectance of the lower layer and free from dissolution and peeling of SiO₂ by the salt spray test.

As an embodiment of the present invention, from the viewpoint of expression of the effect of the present invention, it is preferable from the viewpoint of improving salt water resistance that the content of the Cr contained in the uppermost layer is in the range of more than 0.3 at% and less than 2.3 at%, the content of the Ti contained in the uppermost layer is in the range of more than 0.2 at% and less than 0.8 at%, and the content of the Si contained in in the uppermost layer is in the range of more than 9 at% and less than 31 at%.

The film thickness of the uppermost layer is preferably 15 nm or less because it does not change the spectral reflectance of the lower layer, and more preferably, it is 10 nm or less.

The refractive index with respect to the light wavelength of 587.56 nm of the uppermost layer is preferably 1.6 or less because the spectral reflectance of the lower layer is not changed. A more preferable refractive index is in the range of 1.4 to 1.5.

It is preferable to have a layer containing TiO₂ on the lower layer side of the immediately lower layer from the viewpoint of providing the optical member according to the present invention with a photocatalytic action of self-cleaning (antifouling function).

In addition, from the viewpoint of improving the visibility of images captured as on-vehicle lenses, it is preferable that the optical member of the present invention has an average spectral reflectance of 2% or less with respect to an incidence light from the normal direction in the light wavelength range of 420 to 680 nm.

In the producing method of the optical member to produce the optical member of the present invention, it is preferable that the uppermost layer is formed by using an ion source of an ion assisted deposition method as a sputtering source in order to ensure high productivity.

The present invention and the constitution elements thereof, as well as configurations and embodiments, will be detailed in the following. In the present description, when two figures are used to indicate a range of value before and after "to", these figures are included in the range as a lowest limit value and an upper limit value.

### <<Overview of the optical member of the present invention>>

An optical member of the present invention is an optical member comprising dielectric multilayer films on a substrate, wherein an immediately lower layer of an uppermost layer is a layer containing any one of SiO₂, MgF₂ and Al₂O₃, or a mixture of any combination of SiO₂, MgF₂ and Al₂O₃, and the uppermost layer is a metal oxide layer containing SiO₂ as a main component and also containing at least one of Cr and Ti.

FIG. 2 is a schematic diagram indicating a configuration of an optical member of the present invention.

The dielectric multilayer films 100 having the antireflection function includes, for example, high refractive index layers 103 and 105 having a refractive index higher than that of the glass substrate 101 constituting the lens, and low refractive index layers 102, 104, and 106 having a refractive index lower than that of the high refractive index layer. It is preferable to have a multilayer structure in which these high refractive index layers and low refractive index layers are alternately laminated. From the viewpoint of improving the visibility of images captured as on-vehicle lenses, it is preferable that the optical member of the present invention has an average spectral reflectance of 2% or less with respect to an incidence light from the normal direction in the light wavelength range of 420 to 680 nm.

The immediately lower layer of the uppermost layer according to the present invention refers to the low refractive index layer 106 in FIG. 2, and it is a layer containing any of SiO₂, MgF₂, or Al₂O₃, or a mixture containing layer made of these materials. The immediately lower layer of the uppermost layer may be called as "the adjacent layer to the uppermost layer".

The uppermost layer 107 according to the present invention is a metal oxide layer containing SiO2 as a main component and containing at least one element of Cr or Ti. The refractive index with respect to the light wavelength of 587.56 nm of the uppermost layer is preferably 1.6 or less because the spectral reflectance of the lower layer is not changed as the light reflecting layer. The refractive index may be controlled by appropriately designing the mixing ratio of SiO2, Cr, or Ti. In addition, even when the composition ratio of the uppermost layer is changed and the refractive index exceeds 1.6, it will be possible to form an antireflection layer that can withstand salt spray while maintaining the spectral characteristics very thin.

In the optical member of the present invention indicated in FIG. 2, a low refractive index layer, a high refractive index layer, and an uppermost layer 107 according to the present invention and its immediately lower layer 106 are laminated on a substrate 101 to form dielectric multilayer films. However, the uppermost layer according to the present invention and the immediately lower layer may be formed on both sides of the substrate 101. That is, the uppermost layer and the immediately lower layer according to the present invention are preferably on the side exposed to the external environment, but not the exposed side, for example, the inner side opposite to the exposed side. In order to prevent the influence of the internal environment, the uppermost layer according to the present invention and the immediately lower layer may be formed on the inner side of the substrate. In addition to the lens, the optical member of the present invention may be applied to an optical member such as an antireflection member or a heat shield member.

### [1] Configuration of dielectric multilayer films and manufacturing method thereof

The dielectric multilayer films having an antireflection function comprises a high refractive index layer having a refractive index higher than that of the substrate, and a low refractive index layer having a refractive index lower than that of the high refractive index layer. It is preferable to have a multilayer structure in which these high refractive index layers and low refractive index layers are alternately laminated. The number of layers is not particularly limited, but preferably 12 or less from the viewpoint of the productivity of the antireflective film. The number of layers depends on the required optical performance, but by laminating approximately 3 to 8 layers, the reflectance of the entire visible region may be reduced. It is preferable that the upper limit number is 12 layers or less from the viewpoint of preventing the film from peeling off due to an increase in film stress.

It is preferable that the refractive index to the wavelength 587.56 nm of the high refractive index layer is in the range of 1.9 to 2.45, and the refractive index to the wavelength 587.56 nm of the low refractive index layer is in the range of 1.3 to 1.5.

The material used for the dielectric multilayer films (high refractive index layer, low refractive index layer) according to the present invention is preferably, for example, oxides of Ti, Ta, Nb, Zr, Ce, La, Al, Si, and Hf, a combination of these oxides, and MgF₂ are suitable. By stacking multiple layers of different dielectric materials, it is possible to add the function of reducing the reflectance over the entire visible range.

The above-described low refractive index layer is made of a material having a refractive index lower than that of the substrate. In the present invention, it is preferable that the low refractive index layer is made of SiO₂, or a mixture of SiO₂ and Al₂O₃. In particular, the immediately lower layer of the uppermost layer is preferably a layer containing any of SiO₂, MgF₂, or Al₂O₃, or a mixture containing layer made of these materials from the viewpoint of spectral reflectance.

The above-described high refractive index layer is made of a material having a refractive index higher than that of the substrate. The preferable materials therefor are, for example, a mixture of an oxide of Ta and an oxide of Ti, an oxide of Ti, an oxide of Ta, a mixture of an oxide of La and an oxide of Ti. In the present invention, Ta₂O₅ or TiO₂ is preferable, and Ta₂O₅ is more preferable.

In the optical member of the present invention, it is preferable to use a layer containing TiO₂ as a photocatalyst layer having a self-cleaning function on the lower layer side of the immediately lower layer of the uppermost layer. The self-cleaning function of TiO₂ refers to an organic matter decomposition effect by the photocatalyst. In this case, when TiO₂ is irradiated with ultraviolet light, OH radicals are generated after electrons are emitted, and organic substances are decomposed by the strong oxidizing power of the OH radicals. By adding the TiO₂ containing layer to the optical member of the present invention, it is possible to prevent the optical system from being contaminated with organic matter attached to the optical member. In that case, it is preferable that the upper SiO₂ containing layer has a slightly rough film quality because OH radicals can easily move and the antifouling property of the optical member surface can be improved. This makes it possible to control the film quality by controlling the IAD conditions when forming the upper SiO₂ containing layer.

The thickness of the dielectric multilayer films (the total thickness when a plurality of layers are laminated) is preferably in the range of 50 nm to 5 µm. When the thickness is 50 nm or more, anti-reflection optical characteristics can be exhibited, and when the thickness is 5 µm or less, it is possible to prevent surface deformation due to film stress of the multilayer films itself. As a method of forming a thin film such as the metal oxide on a substrate, there are known evaporation systems such as: vacuum evaporation, ion beam evaporation, and ion plating, and there are known sputtering systems such as: sputtering, ion beam sputtering, and magnetron sputtering. The film forming method for forming the dielectric multilayer films excluding the uppermost layer of the present invention is preferably a vacuum vapor deposition method using an IAD method (hereinafter also referred to as IAD vapor deposition method in the present invention).

The IAD method is a method in which high kinetic energy of ions acts during film formation to form a dense film or increase the adhesion of the film. For example, an ion beam method is a method in which a deposition material is accelerated by ionized gas molecules emitted from an ion source to form a film on a substrate surface. The IAD method is also referred to as "ion beam assist method".

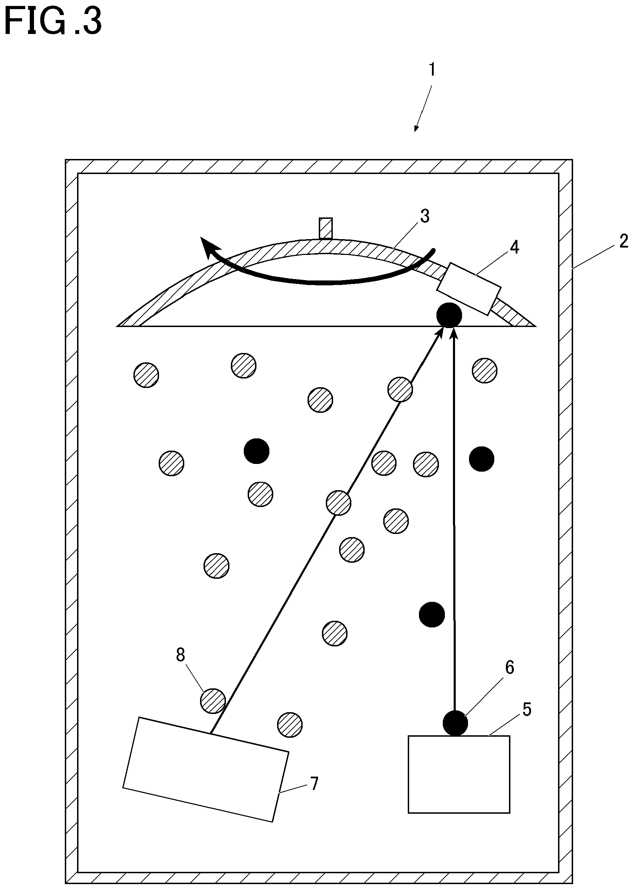

FIG. 3 is a schematic view indicating an example of an IAD vapor deposition apparatus.

A vacuum vapor deposition apparatus 1 using the IAD method (hereinafter also referred to as an IAD vapor deposition apparatus in the present invention) includes a dome 3 in a chamber 2, and a substrate 4 is disposed along the dome 3. A vapor deposition source 5 is equipped with an electron gun for evaporating the vapor deposition substance, and the vapor deposition substance 6 from the vapor deposition source 5 scatters toward the substrate 4 and condenses and solidifies on the substrate 4. At this time, an ion beam 8 is irradiated toward the substrate from an IAD ion source 7 and the high kinetic energy of the ions is applied during the film formation to form a dense film or enhance the adhesion of the film.

Here, the substrate 4 may be glass or a resin. As a resin, a polycarbonate resin and a cycloolefin resin are mentioned.

At the bottom of the chamber 2, a plurality of deposition sources 5 may be disposed. Here, although one vapor deposition source is indicated as the vapor deposition source 5, the number of the vapor deposition sources 5 may be plural. The film forming material (vapor deposition material) of the vapor deposition source 5 is used to generate a vapor deposition substance 6 by an electron gun. The film forming material is scattered and adhered to a substrate 4 (for example, a glass plate) installed in the chamber 2. Thereby, a layer (for example, a SiO₂, MgF₂ or Al₂O₃ layer, which is a low refractive index material layer, and Ta₂O₅ or TiO₂ layer, which is a high refractive index material layer) is formed on the substrate 4.

Further, the chamber 2 is provided with an evacuation system not illustrated, whereby the inside of the chamber 2 is evacuated. The level of vacuum in the chamber is usually in the range of 1 x 10⁻⁴ to 1 Pa, preferably in the range of 1 x 10 3 to 1 x 10⁻² Pa.

The dome 3 has at least one holder (not illustrated) that holds the substrate 4 and is also called a vapor deposition umbrella. The dome 3 has an arc shape in cross section, and has a rotationally symmetrical shape that passes through the center of a chord connecting both ends of the arc and rotates with an axis perpendicular to the chord as an axis of rotational symmetry. By rotating the dome 3 around the axis, for example, at a constant speed, the substrate 4 held by the dome 3 via the holder revolves around the axis at a constant speed.

The dome 3 can hold a plurality of holders side by side in a rotational radial direction (revolutional radial direction) and a rotational direction (revolutional direction). As a result, it becomes possible to simultaneously form a film on a plurality of substrates 4 held by a plurality of holders, and the manufacturing efficiency of the device may be improved.

The IAD ion source 7 is an apparatus for introducing argon or oxygen gas into the inside of the main body to ionize them, and irradiating the substrate 4 with ionized gas molecules (ion beam 8). As the ion source, a Kauffman type (filament), a hollow cathode type, an RF type, a bucket type, or a duoplasmatron type may be applied. By irradiating the substrate 4 with the above-described gas molecules from the IAD ion source 7, for example, molecules of a film forming material evaporated from a plurality of evaporation sources may be pressed onto the substrate 4. Thereby, a film with high adhesion and high density may be formed on the substrate 4. The IAD ion source 7 is disposed to face the substrate 4 at the bottom of the chamber 2, but may be disposed at a position offset from the opposing axis.

The ion beam used in the AD method is used at a low degree of vacuum and the acceleration voltage tends to be lower than the ion beam used in the ion beam sputtering method. For example, an ion beam with an acceleration voltage of 100 to 2000 V and an ion beam with a current density of 1 to 120 µA/cm² may be used. In the film forming step, the irradiation time of the ion beam may be, for example, 1 to 800 seconds, and the number of particle irradiation of the ion beam maybe, for example, 1 x 10¹³ to 5 x 10¹⁷/cm². The ion beam used in the film formation process may be an ion beam of oxygen, an ion beam of argon, or an ion beam of a mixed gas of oxygen and argon. For example, it is preferable to set the oxygen introduction amount in the range of 30 to 60 sccm and the argon introduction amount in the range of 0 to 10 sccm.

The monitor system (not illustrated) is a system for monitoring the characteristics of the layer formed on the substrate 4 by monitoring the layer evaporated from each deposition source 5 and attached to itself during vacuum film formation. By this monitor system, optical characteristics (for example, light transmittance, light reflectance, and optical film thickness) of a layer formed on the substrate 4 may be grasped. The monitoring system also includes a quartz crystal thickness monitor, which can also monitor the physical thickness of the layer deposited on the substrate 4. The monitor system also functions as a control unit that controls ON/OFF switching of the plurality of evaporation sources 5, and ON/OFF switching of the IAD ion source 7 according to the layer monitoring result.

### [2] Configuration of uppermost layer and manufacturing method thereof

The uppermost layer according to the present invention is a metal oxide layer containing SiO₂ as a main component and containing at least one element of Cr or Ti. Here, the main component means that Si is contained most as an element contained in the uppermost layer.

From the viewpoint of the function as a low refractive index layer and the function of improving salt water resistance, it is preferable that the content of Si contained in the uppermost layer is in the range of more than 9 at% and less than 31 at%, the content of Cr contained in the uppermost layer is more than 0.3 at% and 2.3 at% %, and the Ti content is more than 0.2 at% and less than 0.8 at%.

As a preferable method for forming the uppermost layer of the present invention, it is preferable to use an ion source used in the IAD method as a sputtering source in order to ensure high productivity.

By performing such sputtering film formation, it is possible to form a mixed film containing a metal oxide such as SiO₂ as a main component on a substrate at an unprecedented slow film forming rate of 10 pm/sec or less. Since the film forming rate is on the order of pm/sec, a film forming rate on the order of 1/10 to 1/100 is realized as compared with the conventional vapor deposition method and sputtering method, it is possible to produce homogeneous very thin films (e.g., film thickness in the range of 5 nm or less).

Hereinafter, the film forming method of the present invention will be described with reference to the drawings.

### <First embodiment: Film forming method using ion beam sputtering apparatus>

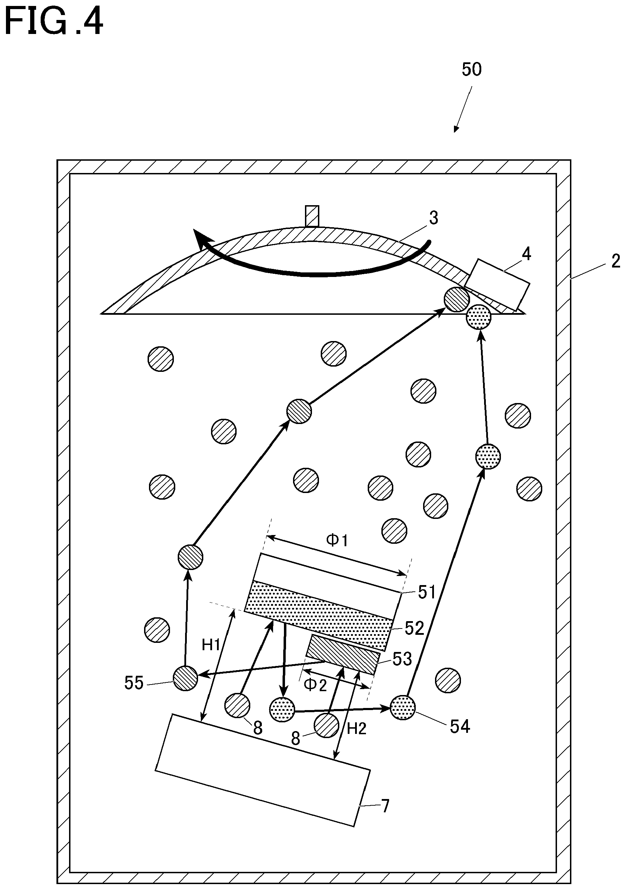

FIG. 4 is a schematic view of an ion beam sputtering film forming apparatus for sputtering by an ion beam emitted from an ion source according to the present invention. However, this figure is an example and the present invention is not limited to this.

An ion beam sputtering film forming apparatus 50 according to the present invention includes a dome 3 in a chamber 2 similarly to the IAD vapor deposition apparatus of FIG. 3, and a substrate 4 is disposed along the dome 3.

The sputtering source is an IAD ion source 7, and an ion beam 8 emitted from the IAD ion source 7 is directed to a first sputtering target 52 and a second sputtering target 53. Although FIG. 4 describes the case of performing dual sputtering, the number of sputtering targets may be one.

The first sputtering target 52 and the second sputtering target 53 are disposed on a target holder 51 located between the substrate 4 and the IAD ion source 7. A surface of the first sputtering target 52 and the second sputtering target 53 opposite to a surface facing the substrate 4 is sputtered by the ion beam 8 from the IAD ion source 7 to generate and scatter sputtered particles 54 and 55, and a film is formed on the substrate 4.

Sputtering targets may be stacked with one or more film deposition materials, and simultaneous multi-source sputtering is possible. In FIG. 4, for example, a first sputtering target 52 mainly composed of TiO₂ and a second sputtering target 53 mainly composed of SiO₂ are disposed in an overlapping manner, and simultaneous dual sputtering is performed.

The feature of the present invention is that the sputtered particles 54 and 55 are generated by sputtering by the ion beam 8 on a surface opposite to a surface facing the substrate 4 and not on the surface directly facing the substrate. Therefore, the sputtered particles 54 and 55 scatter toward the substrate while bypassing the sputtering target to contribute to film formation, and therefore, the film forming rate may be reduced.

Therefore, in addition to the ion beam irradiation time, the control factors of the film forming rate are the size of the sputtering target (Φ in the figure), the distance from the IAD ion source to the sputtering target (H in the figure), the distance from the sputtering target to the substrate 4. Therefore, it is not necessary to perform adjustment such as lowering the ion beam irradiation intensity to adjust the d film forming rate as in the prior art. Compared to known vapor deposition methods and sputtering methods, a film forming rate of 10 pm/sec or less, corresponding to 1/10 to 1/100 of the film forming rate may be realized, and it is possible to produce homogeneous, extremely thin films.

The film forming rate is preferably 5 pm/sec or less, more preferably in the range of 0. 1 to 3 pm/sec.

In addition, from the viewpoint of adjusting the film forming rate, the sputtering target preferably changes the angle facing the IAD ion source, in addition to the distance (H) from the IAD ion source. Further, forming a film by sputtering while rotating the sputtering target, or forming a film by sputtering while lifting the film is also a preferable method from the viewpoint of adjusting the film forming speed and the composition of the film forming material.

Regarding the multi-source sputtering, in the sputtering target according to the present invention, it is preferable that the sputtering surface of the target has a metal surface and a glass surface.

The metal surface preferably contains at least one element of Ti, Cr, Ni and Al from the viewpoint of improving the salt water resistance as an uppermost layer.

Further, it is preferable that the glass surface is mainly composed of SiO₂ and contains at least one element of Ta, Zr and Na from the viewpoint of improving the durability against alkali and acid as an uppermost layer and ensuring the environmental resistance.

Further, it is also preferable to use Ta₂O₅, ZrO₂ or ZnO as a sputtering target by changing the components of the glass, from the viewpoint of improving the durability to the alkali and the acid.

The preferable example of arrangement of the film forming material of the sputtering target in the case of performing multi-source sputtering is indicated below.

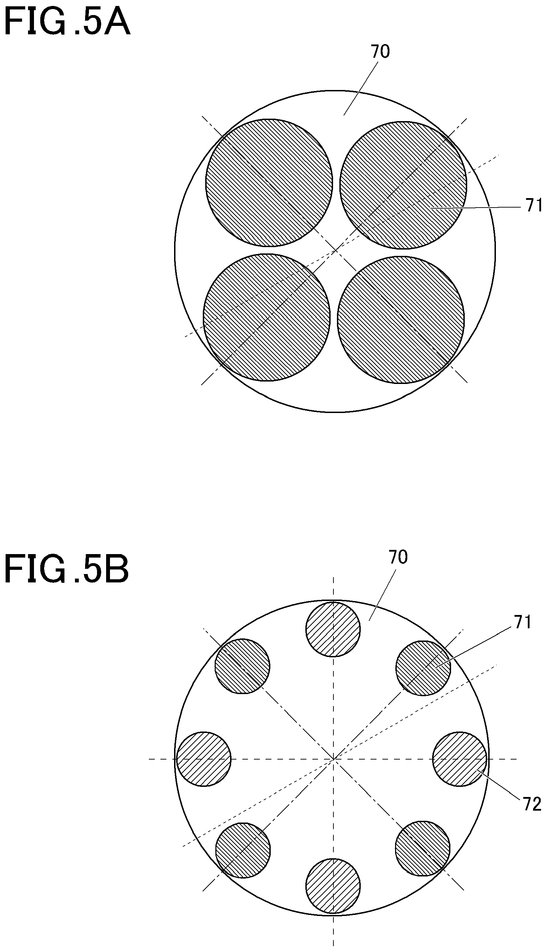

FIG. 5 is a schematic view indicating an arrangement of sputtering targets when using a plurality of film forming materials.

FIG. 5A is a schematic view indicating an arrangement of the film forming material in the sputtering target when there are two film forming materials.

A first sputtering target 70 is formed in a disk shape, and second sputtering targets 71, which are film forming materials to be mixed, are arranged opposite to each other along the outer periphery of the first sputtering target. It is preferable to arrange equally at four positions so as to be at an angle of 90°. The circle of the second sputtering target 71 indicates the position of the arrangement, and the size thereof does not indicate the size of the sputtering target.

FIG. 5B is a schematic view indicating an arrangement of the film forming material in the sputtering target when there are three film forming materials.

The first sputtering target 70 is formed in a disk shape, and the second sputtering targets 71, which are film forming materials to be mixed, face each other and are arranged at four positions so as to form an angle of 90°. Further, it is preferable to equally arrange the third sputtering targets 72 at four positions having an angle of 45° with the second sputtering targets 71.

In any case, when sputtering is performed while rotating the sputtering target, the generation of sputtered particles may be made uniform, which is preferable.

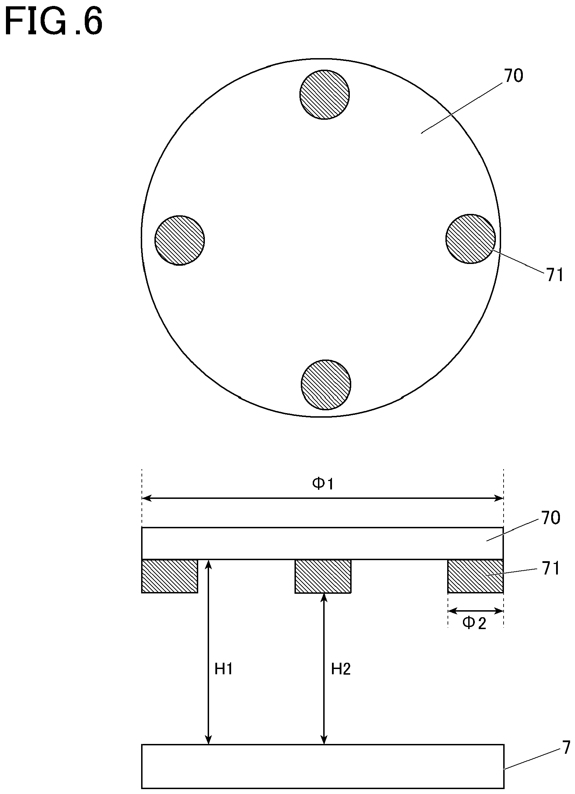

FIG. 6 is a plan view and a sectional view indicating an arrangement of specific sputtering targets in the case of two film forming materials.

The first sputtering target 70 is formed in a disk shape, and the second sputtering targets 71, which are film forming materials to be mixed, face each other, and are evenly arranged at four positions so as to form an angle of 90°. The size of the first sputtering target 70 is represented by Φ1 (unit mm), and the size of the second sputtering target 71 is represented by Φ2 (unit mm).

The above-described Φ1 is preferably in the range of 100 to 500 mm, and more preferably in the range of 200 to 400 mm. The above-described Φ2 is preferably in the range of 10 to 100 mm, and more preferably in the range of 20 to 80 mm. The thickness of both is preferably in the range of 1 to 5 mm.

The distance from the IAD ion source 7 to the first sputtering target 70 is indicated by HI (unit mm), and the distance to the second sputtering target 71 is indicated by H2 (unit mm).

The above-described H1 and H2 are preferably in the range of 50 to 200 mm, and more preferably in the range of 100 to 150 mm.

The above-described Φ1, Φ2, H1 and H2 are appropriately determined as control factors of the film forming speed and the mixing ratio.

The film forming apparatus used in the uppermost layer forming method of the present invention has a means capable of arranging the sputtering target between the substrate and the ion source at a desired timing. It is preferable that a surface opposite to a surface facing the substrate of the sputtering target to be disposed is sputtered by an ion beam emitted from the ion source to form a film on the substrate.

By having a means capable of arranging the sputtering target in the apparatus at a desired timing, a lower dielectric multilayer film is deposited on the substrate by the IAD method using the IAD vapor deposition apparatus indicated in FIG. 3, and then the sputtering target is introduced into the apparatus to face the IAD ion source, as indicated in FIG. 4. The sputtering film formation may be performed in an ion beam sputtering film forming apparatus.

The means by which the sputtering target may be disposed at a desired timing is not particularly limited. As an example, there may be mentioned an introduction means for moving a sputtering target prepared in advance outside the apparatus along a guide rail provided inside the apparatus from a window-like entrance provided in the chamber.

### <Second embodiment: Film forming method using film forming apparatus including IAD vapor deposition apparatus and ion beam sputtering apparatus>

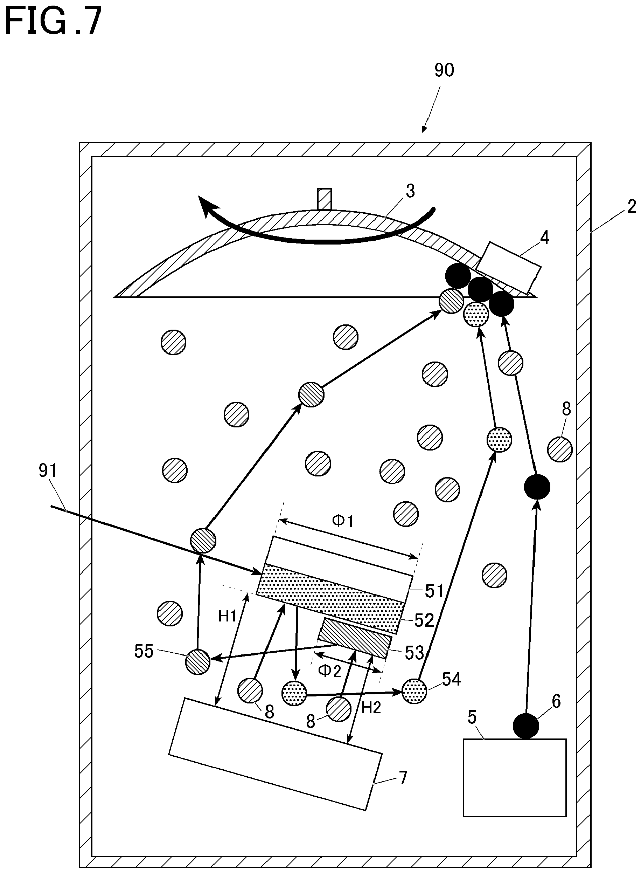

FIG. 7 is a schematic view indicating an example of a film forming apparatus having both an IAD vapor deposition apparatus and an ion beam sputtering apparatus capable of continuously forming an undercoat film and a protective film according to the present invention.

A film forming apparatus 90 includes a dome 3 in a chamber 2 similarly to the vapor deposition apparatus of FIG. 3, and a substrate 4 is disposed along the dome 3. A vapor deposition source 5 is equipped with an electron gun for evaporating the vapor deposition substance, and a vapor deposition substance 6 from the vapor deposition source 5 scatters toward the substrate 4 and condenses and solidifies on the substrate 4. At this time, an ion beam 8 is irradiated toward the substrate from an IAD ion source 7 and the high kinetic energy of the ions is applied during the film formation to form a dense film or enhance the adhesion of the film.

A plurality of vapor deposition sources are prepared.
For example, dielectric multilayer films in which a SiO₂ containing layer which is a low refractive index layer and a Ta₂O₅ containing layer which is a high refractive index layer are alternately laminated is formed as an under layer of the uppermost layer. The immediately lower layer of the uppermost layer is a layer containing any of SiO₂, MgF₂, or Al₂O₃, or a mixture containing layer made of these materials. Furthermore, it is preferable to provide a photocatalyst layer containing TiO₂ having a self-cleaning function as a layer below it.

Then, the operation of the vapor deposition source 5 is stopped, and the sputtering target 52 (53) prepared in advance outside the apparatus is moved along the sputtering target introduction means 91 such as a guide rail provided inside the apparatus from the window-like entrance. It is placed on a target holder 51 located between the substrate 4 and the IAD ion source 7.

The ion source is an IAD ion source 7, and the ion beam 8 emitted from the IAD ion source 7 is irradiated on a surface of the first sputtering target 52 and the second sputtering target 53 opposite to a surface facing the substrate 4 to perform sputtering. The first sputtered particles 54 and the second sputtered particles 55 are scattered, and film formation is made on the dielectric multilayer films which is a undercoat film formed in advance on the substrate 4, and a laminate of dielectric multilayer films 100 and an uppermost layer 107 are formed on the substrate.

The thickness of the uppermost layer is preferably 15 nm or less, and is preferably in the range of 1 to 10 nm, more preferably in the range of 1 to 5 nm, from the viewpoint of excluding the influence on the light reflectance of the lower layer.

Preferable film forming conditions of the uppermost layer are as follows: the level of reduced pressure in the chamber is usually in the range of 1 x 10⁻⁴ to 1 Pa, preferably in the range of 1 x 10⁻³ to 1 x 10⁻² Pa, the film forming rate is in the range of 1 to 10 pm/sec, by using the RF ion source "OIS One" made by Optorun Co. Ltd., the acceleration voltage output of the ion beam is in the range of 500 to 1500 V, the acceleration current is in the range of 300 to 1500 mA, the bias current is in the range of 500 to 2000 mA, the introduction amount of oxygen is in the range of 20 to 60 sccm, and the introduction amount of argon is in the range of 0 to 15 sccm.

### [3] Optical members for on-vehicle use or outdoor use

The optical member of the present invention may be an on-vehicle or outdoor optical lens, and in particular, a lens for an on-vehicle camera (a lens forming a lens unit) is preferable.

The "on-vehicle camera" is a camera installed on the outer side of the vehicle body. It is installed in the rear part of the vehicle body and used for backward confirmation, or installed in the front part of the vehicle body and used for forward confirmation or lateral confirmation, for confirmation of the distance to the front vehicle.

Such a lens unit for an on-vehicle camera is constituted by a plurality of lenses, and more specifically, it is constituted by an object-side lens disposed on the object-side and an image-side lens group disposed on the image-side. The image-side lens unit includes a plurality of lenses and a stop provided between the lenses.

Among the plurality of lenses, the object-side lens is an exposed surface exposed to the outside air, and the optical thin film is provided on the lens having the exposed surface.

Examples of the outdoor optical member include an outdoor installation type surveillance camera, and the optical thin film is used on a lens having an exposed surface exposed to the outside air among lenses constituting the surveillance camera.

Although the embodiments of the present invention have been described and illustrated in detail, the disclosed embodiments are made for purpose of illustration and example only and not limitation. The scope of the present invention should be interpreted by terms of the appended claims.

### Examples

Hereinafter, the present invention will be specifically described by way of examples, but the present invention is not limited thereto. In addition, although the term "part" or "%" is used in examples, unless otherwise indicated, it represents "mass part" or "mass%".

### <Preparation of optical member sample example 1>

Using the film forming apparatus having both the IAD vapor deposition apparatus and the ion beam sputtering apparatus indicated in FIG. 7, vapor deposition by the IAD method and sputtering film formation using an IAD ion source were performed under the following conditions. The film forming materials used in the examples are as follows.

### <Film forming materials>

SiO₂: manufactured by Merck, Product name SiO₂
Ta₂O₅: manufactured by Canon Optron, Inc., Product name A600
TiO₂: manufactured by Fuji Titanium Co., Ltd. Product name TiO₂
MgF₂: manufactured by Merck, Product name MgF₂
Al₂O₃: manufactured by Merck, Product name Al₂O₃
SUS304: Stainless steel

### <Substrate>

### Glass substrate

### <Formation of dielectric multilayer films>

### (Conditions in the Chamber)

Heating temperature: 300 °C
Initial level of vacuum: 1.33 x 10⁻³ Pa

### (Evaporation source of film forming material)

Electron gun

### (Formation of low refractive index layer and high refractive index layer)

Film forming material for low refractive index layer: SiO₂ (manufactured by Merck, Product name SiO₂)

The substrate was placed in a vacuum deposition apparatus, the film forming material was loaded into the first evaporation source, a film was deposited at a deposition rate of 3 Å/sec, and a low refractive index layer with a thickness of 24.9 nm was formed on the substrate.

The low refractive index layer was formed by the IAD method, using an apparatus of RF ion source "OIS One" made by Optorun Co. Ltd. with an acceleration voltage of 1200 V, an acceleration current of 1000 mA, and a neutralization current of 1500 mA. The IAD introduction gas was set as: O₂ 50 sccm, Ar gas 0 sccm, and neutral gas O₂ 50 sccm.

### Film forming material for high refractive index layer: Ta₂O₅ (manufactured by Canon Optron, Inc., Product name A600)

The substrate was placed in a vacuum deposition apparatus, the film forming material was loaded into the second evaporation source, a film was deposited at a deposition rate of 3 Å/sec, and a high refractive index layer with a thickness of 26.4 nm was formed on the low refractive index layer. The high refractive index layer was formed by the IAD method in the same way as formation of the low refractive index layer.

On the formed high refractive index layer, a low refractive index layer and a high refractive index layer were formed under the film thickness conditions described in Table I to produce a total of five dielectric multilayer films (the notation (IAD) after the film formation material indicates that the IAD method was used).

### <Formation of uppermost layer>

After the formation of the dielectric multilayer films, the operation of the evaporation source was stopped, the following sputtering target was introduced into the chamber, and the uppermost layer was formed by sputtering film formation using the IAD ion source as a sputtering source. The film forming material on the sputtering target was arranged as shown in FIG. 6.

### (Sputtering target: A material)

First sputtering target SUS304, HI: 125 mm, Φ1: 285 mm
Second sputtering target SiO₂ (quartz glass), H2: 119 mm, Φ2: 50 mm (IAD ion source)
RF ion source "OIS One" made by Optorun Co., Ltd.
Acceleration voltage (V): 1200
Acceleration current (mA): 1000
Neutralization current (mA): 1500

### (Conditions in the Chamber)

Heating temperature: 300 °C
Conditions of IAD introduction gas were set as: O₂ 50 sccm, Ar gas 0 sccm, and neutral gas O₂ 50 sccm.

Level of vacuum: 1 x 10⁻² Pa

Under the above conditions, the ion beam irradiation time from the IAD ion source was set to 165 minutes, and the surface of the sputtering target opposite to the surface facing the substrate was sputtered with the ion beam. According to the following film thickness measurement, the uppermost layer mixed with Si, Cr, Ni, and Fe having a film thickness of 15 nm was formed at a film forming rate of 1.52 pm/sec.

The composition of the uppermost layer was measured by the following X-ray photoelectron spectrometer (XPS), and had the elemental composition described in Table V.

### <Film thickness measurement>

The film thickness was measured by the following method.
(1) TiO₂ and SiO₂ are formed in a film thickness of 1/4 λ (λ = 550 nm) on a white sheet glass substrate in advance, and the light reflectance is measured.
(2) A film is formed on the TiO₂ and SiO₂ films as described in (1) above under the conditions for forming an protective film, the light reflectance is measured, and the refractive index and the film thickness of the uppermost layer are calculated from the amount of change.

The light reflectance was measured at a light wavelength of 550 nm with a spectrophotometer U-4100 manufactured by Hitachi High-Technologies Corporation.

### <XPS composition analysis>

Device name: X-ray photoelectron spectroscopy (XPS)
Device type: Quantera SXM
Device manufacturer: ULVAC-PHI
Measurement conditions: X-ray source: monochromating AlKα ray 25 W-15 kV
Level of vacuum: 5.0 x 10⁻⁸ Pa
Depth direction analysis was performed by argon ion etching. For data processing, MultiPak manufactured by ULVAC-PHI, Inc. was used.

### <Preparation of optical member sample examples 2, 3, 4, 9, 11, 13, 14, 15, 19, 20, 23, 24, and 27>

In the same manner as in the preparation of the optical member sample Example 1, dielectric multilayer films having the layer constitution and film thickness indicated in Tables I to III were formed, and then the uppermost layer was formed under the conditions indicated in Tables V and VI. Thus, optical member sample examples 2, 3, 4, 9, 11, 13, 14, 15, 19, 20, 23, 24 and 27 were prepared.

An example sample using MgF₂ (trade name: MgF₂ manufactured by Merck) as a low refractive index material was formed using an electron gun at a film forming rate of 3 mm/sec.

In optical member sample examples 13, 14, 15, 23, and 24, a photocatalyst layer using TiO₂ was formed as a lower layer of the uppermost layer of the dielectric multilayer films.

In optical member sample example 27, as indicated in Table III, SiO₂ and Al₂O₃ were mixed at a mass ratio of 97: 3 as the uppermost layer of the dielectric multilayer films.

### <Preparation of optical member sample example 5>

In the same manner as the preparation of the optical member sample Example 1, five-layered dielectric multilayer films were formed as described in Table I.

### <Formation of uppermost layer>

After the formation of the dielectric multilayer films, the operation of the evaporation source was stopped, the following sputtering target was introduced into the chamber, and the uppermost layer was formed by sputtering film formation using the IAD ion source as a sputtering source. The film forming material on the sputtering target was arranged as shown in FIG. 6.

### (Sputtering target: B material)

First sputtering target TiO₂, HI: 125 mm, Φ1: 285 mm
Second sputtering target SiO₂ (quartz glass), H2: 119 mm, Φ2: 50 mm

### <Preparation of optical member sample examples 6, 7, 8, 10, 12, 16, 17, 18, 21, 22, 25, and 26>

In the same manner as in the preparation of the optical member sample example 5, the uppermost layer was formed under the conditions indicated in Table VI and Table VII, and the optical member sample examples 6, 7, 8, 10, 12, 16, 17, 18 21, 22, 25 and 26 were prepared.

### <Preparation of optical member sample comparative examples 1 to 6>

Optical member sample comparative examples 1 to 6 having the configuration indicated in Table IV were prepared in the same manner as in the production of optical member sample examples 1 to 27 except that the uppermost layer was not formed.

### <<Evaluation>>

The following evaluation was carried out using the obtained optical member sample examples 1 to 27 and optical member sample comparative examples 1 to 6.

### (1) Measurement of spectral reflectance

Using a spectrophotometer U-4100 manufactured by Hitachi High-Technology Co., Ltd. in the light wavelength range of 350 to 800 nm, the spectral reflectance with respect to an incidence light from the normal direction was measured.

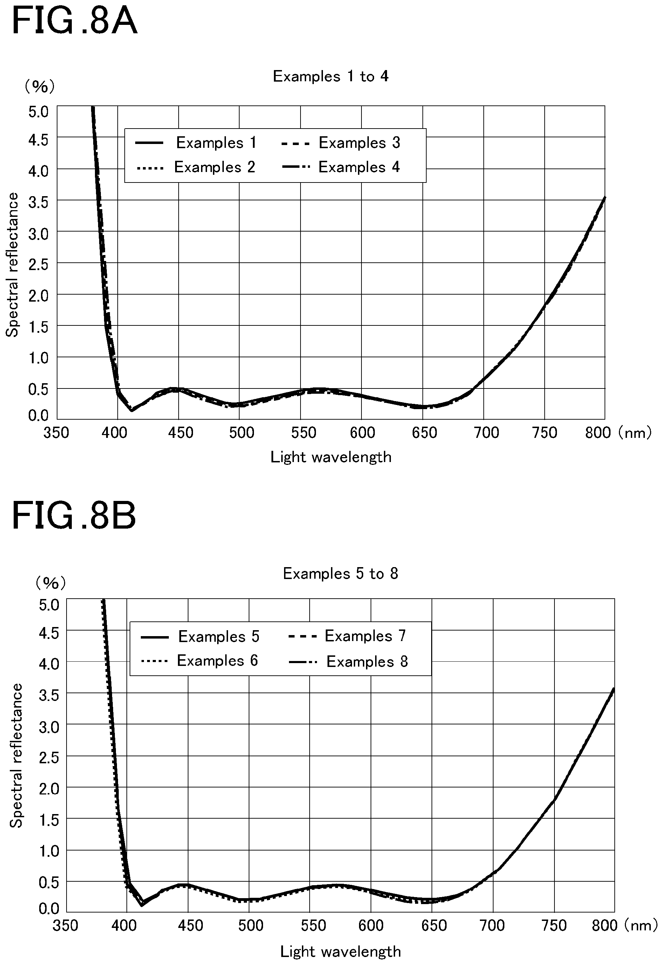

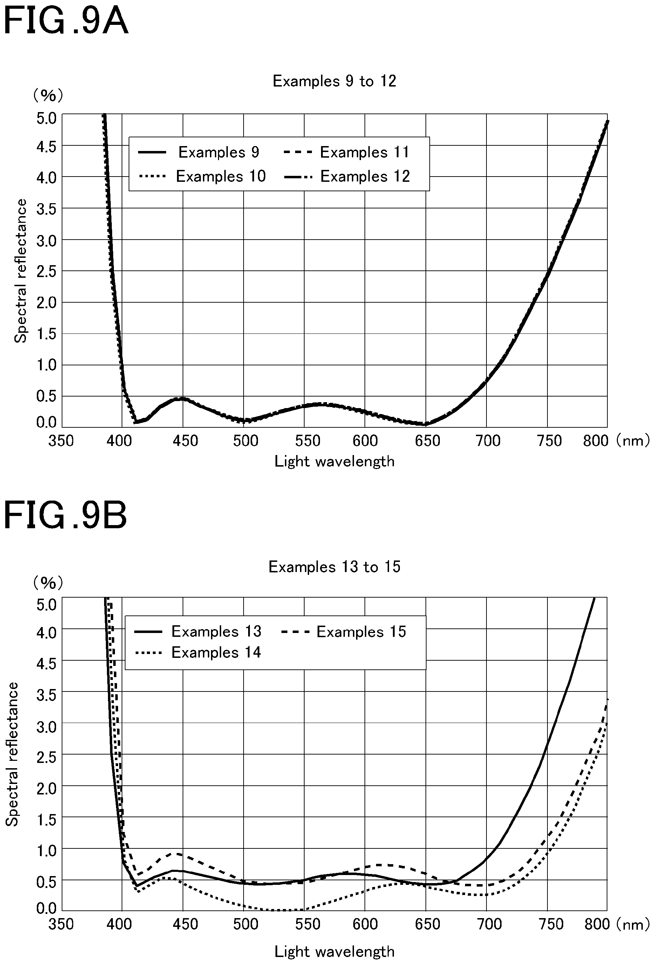

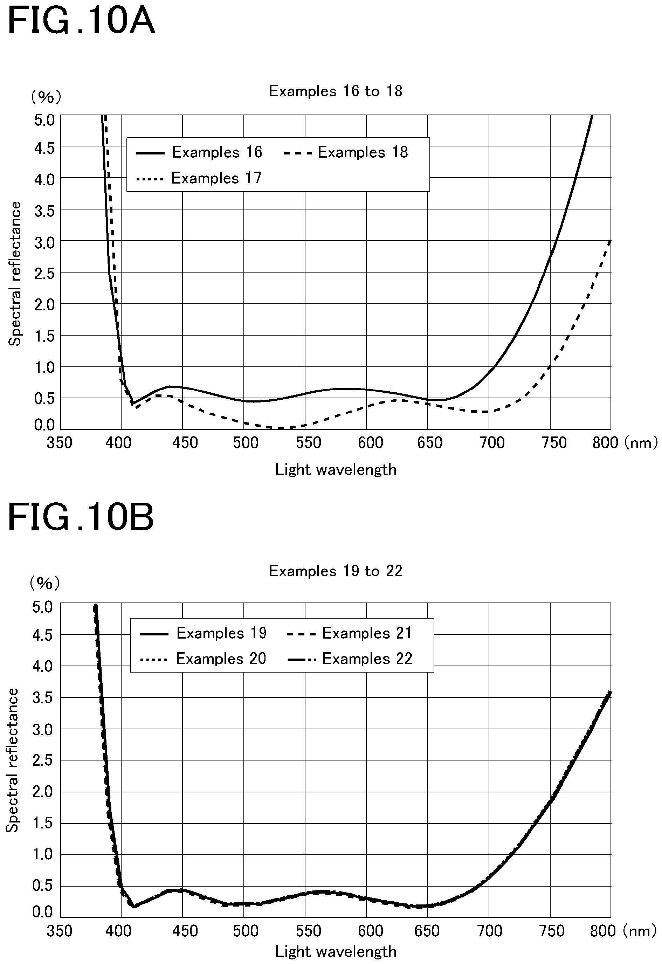

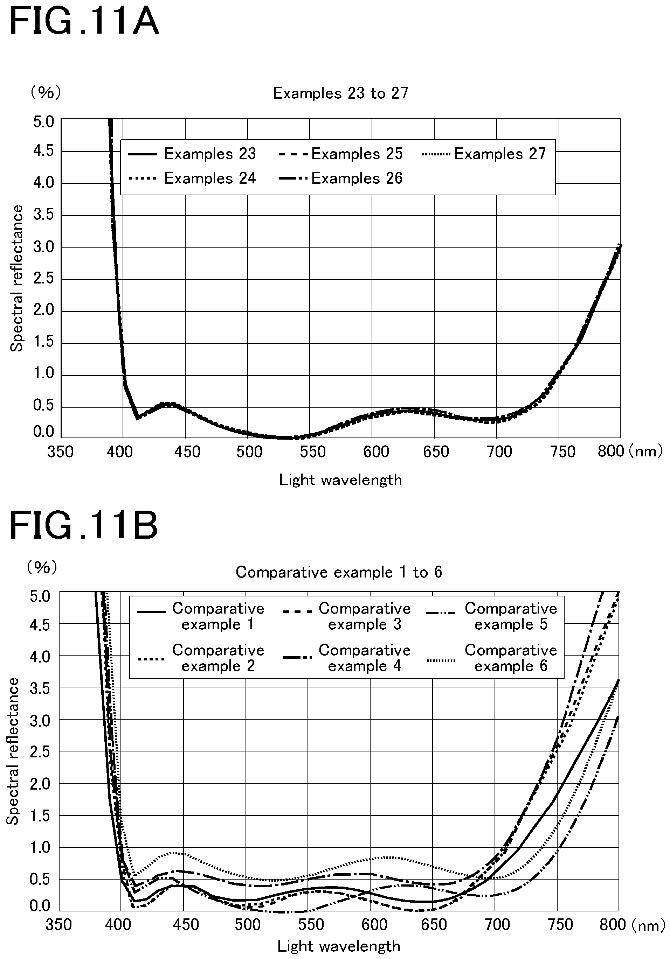

The measurement results are indicated in FIG. 8 to FIG. 11. All of the optical members of the inventive examples were confirmed to have an average spectral reflectance of 2% or less with respect to an incidence light from the normal direction in the light wavelength range of 420 to 680 nm.

### (2) Salt spray test

The following evaluation was performed using the obtained optical member sample.

### <Salt spray test>

The following steps (a) to (c) are considered as 1 cycle, and 8 cycles were carried out.
(a) The solvent at 25 ± 2 °C is sprayed on the uppermost layer of the sample for 2 hours at a temperature in the spray tank of 35 ± 2 °C).
(b) After spraying, leave the sample at 40 ± 2 °C and 95 %RH for 22 hours.
(c) After repeating (a) and (b) four times, leave the sample at 25 °C and 55 %RH for 72 hours.

### <Solvent>

Solute used: NaCl, MgCl₂, CaCl₂
Solute concentration: 5 ± 1% (mass ratio)

### <Measurement of spectral reflectance>

The spectral reflectance of the optical member sample before and after the salt spray test was measured, and the average value of the spectral reflectance in the light wavelength range of 420 to 680 nm was evaluated. When the variation was within 0.1%, it was ranked as passing the examination (designated as ○).

### (3) Photocatalytic effect evaluation method

The following evaluation was performed using the obtained optical member sample.

### (a) Lighting arrangement

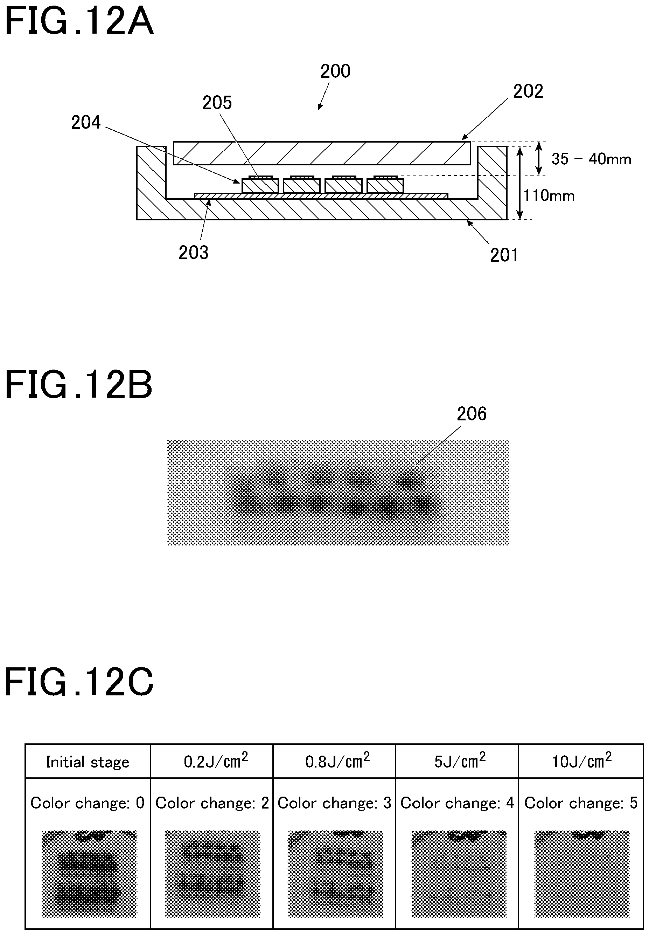

FIG. 12A indicates a schematic diagram of the illumination device 200 for evaluation.

A UV light 202 is installed on a black container box 201.

The sample is placed on a flat plate 203 with a marker surface 205 on an uppermost layer side of an optical member sample 204 set to the UV light 202 side.

Adjust the height so that the distance between the UV light 202 and the optical member sample 204 is about 35 to 40 mm.

### (b) How to paint sample with a pen

On the photocatalytic surface, draw a line with The Visualizer pen made of Ink intelligent Corporation.

This is done with a manner of dropping ink in a dotted pattern 206, as indicated in FIG. 12B, rather than drawing a line.

Ink is applied in 5 points in one step x 2 times.

### (c) UV light irradiation

The lamp lights up when a plug of the UV light is inserted into a socket.

Irradiate with UV light at a height of 35 to 40 mm and an integrated light amount of 10 J for 1 hour.

Check the color change after 1 hour and 2 hours. The color change is illustrated in FIG. 12C.

### (d) Color evaluation

Since the color is not stable immediately after removal of the sample, the color change at each time is evaluated after 30 minutes or more after removal. When there is a photocatalytic effect, the color change becomes transparent from blue (in this case, "photocatalytic effect" is present).

Tables I to VII below indicate the configuration, production method, and evaluation results of the optical member samples.

**Table I**

| No. | Example 1 | Example 2 | Example 3 | Example 4 | Example 5 | Example 6 | Example 7 | Example 8 | Example 9 | Example 10 |
|---|---|---|---|---|---|---|---|---|---|---|
| Number of layers | Air | Air | Air | Air | Air | Air | Air | Air | Air | Air |
| 6 | A material | A material | A material | A material | B material | B material | B material | B material | A material | B material |
| 5 | SiO₂(IAD) | SiO₂(IAD) | SiO₂ (IAD) | SiO₂(IAD) | SiO₂(IAD) | SiO₂(IAD) | SiO₂(IAD) | SiO₂(IAD) | MgF₂ | MgF₂ |
| 4 | Ta₂O₅(IAD) | Ta₂O₅(IAD) | Ta₂O₅(IAD) | Ta₂O₅(IAD) | Ta₂O₅(IAD) | Ta₂O₅(IAD) | Ta₂O₅(IAD) | Ta₂O₅(IAD) | Ta₂O₅(IAD) | Ta₂O₅(IAD) |
| 3 | SiO₂(IAD) | SiO₂(IAD) | SiO₂(IAD) | SiO₂(IAD) | SiO₂(IAD) | SiO₂(IAD) | SiO₂(IAD) | SiO₂(IAD) | SiO₂(IAD) | SiO₂(IAD) |
| 2 | Ta₂O₅(IAD) | Ta₂O₅(IAD) | Ta₂O₅(IAD) | Ta₂O₅(IAD) | Ta₂O₅(IAD) | Ta₂O₅(IAD) | Ta₂O₅(IAD) | Ta₂O₅(IAD) | Ta₂O₅(IAD) | Ta₂O₅(IAD) |
| 1 | SiO₂(IAD) | SiO₂(IAD) | SiO₂(IAD) | SiO₂(IAD) | SiO₂(IAD) | SiO₂(IAD) | SiO₂(IAD) | SiO₂(IAD) | SiO₂(IAD) | SiO₂(IAD) |
| | //Substrate// | //Substrate// | //Substrate// | //Substrate// | //Substrate// | //Substrate// | //Substrate// | //Substrate// | //Substrate// | //Substrate// |
| Number of layers | Film thickness (nm) | | | | | | | | | |
| 6 | 15 | 10 | 5 | 1 | 15 | 11 | 5 | 1 | 3 | 3 |
| 5 | 68.3 | 74.6 | 81.0 | 81.0 | 78.8 | 82.0 | 86.4 | 86.4 | 87.5 | 86.7 |
| 4 | 130.1 | 130.1 | 130.1 | 130.1 | 130.1 | 130.1 | 130.1 | 130.1 | 128.3 | 128.3 |
| 3 | 29.4 | 29.4 | 29.4 | 29.4 | 29.4 | 29.4 | 29.4 | 29.4 | 35.5 | 35.5 |
| 2 | 26.4 | 26.4 | 26.4 | 26.4 | 26.4 | 26.4 | 26.4 | 26.4 | 23.2 | 23.2 |
| 1 | 24.9 | 24.9 | 24.9 | 24.9 | 24.9 | 24.9 | 24.9 | 24.9 | 39.8 | 39.8 |
| Salt spray | ○ | ○ | ○ | ○ | ○ | ○ | ○ | ○ | ○ | ○ |
| Photocatalytic effect | Absent | Absent | Absent | Absent | Absent | Absent | Absent | Absent | Absent | Absent |

**Table II**

| No. | Example 111 | Example 12 | Example 13 | Example 14 | Example 15 | Example 16 | Example 17 | Example 18 | Example 191 | Example 20 | Example 21 |
|---|---|---|---|---|---|---|---|---|---|---|---|
| Number of layers | | | | | Air | | | Air | | | |
| 9 | | | Air | Air | A material | Air | Air | B material | | | |
| 8 | Air | Air | A material | A material | SiO₂ | B material | B material | SiO₂ | | | |
| 7 | A material | B material | MgF₂ | SiO₂ | MgF₂ | MgF₂ | SiO₂ | MgF₂ | Air | Air | Air |
| 6 | SiO₂(IAD) | SiO₂(IAD) | TiO₂(IAD) | TiO₂(IAD) | TiO₂(IAD) | TiO₂(IAD) | TiO₂(IAD) | TiO₂(IAD) | A material | A material | B material |
| 5 | MgF₂ | MgF₂ | SiO₂(IAD) | SiO₂(IAD) | SiO₂(IAD) | SiO₂(IAD) | SiO₂(IAD) | SiO₂(IAD) | SiO₂(IAD) | SiO₂(IAD) | SiO₂(IAD) |
| 4 | Ta₂O₅(IAD) | Ta₂O₅(IAD) | Ta₂O₅(IAD) | Ta₂O₅(IAD) | Ta₂O₅(IAD) | Ta₂O₅(IAD) | Ta₂O₅(IAD) | Ta₂O₅ (IAD) | Ta₂O₅(IAD) | Ta₂O₅(IAD) | Ta₂O₅(IAD) |
| 3 | SiO₂(IAD) | SiO₂ (IAD) | SiO₂(IAD) | SiO₂(IAD) | SiO₂(IAD) | SiO₂(IAD) | SiO₂(IAD) | SiO₂(IAD) | SiO₂(IAD) | SiO₂(IAD) | SiO₂(IAD) |
| 2 | Ta₂O₅(IAD) | Ta₂O₅(IAD) | Ta₂O₅(IAD) | Ta₂O₅(IAD) | Ta₂O₅(IAD) | Ta₂O₅(IAD) | Ta₂O₅(IAD) | Ta₂O₅(IAD) | Ta₂O₅(IAD) | Ta₂O₅(IAD) | Ta₂O₅(IAD) |
| 1 | SiO₂(IAD) | SiO₂(IAD) | SiO₂(IAD) | SiO₂(IAD) | SiO₂(IAD) | SiO₂(IAD) | SiO₂(IAD) | SiO₂(IAD) | SiO₂(IAD) | SiO₂(IAD) | SiO₂(IAD) |
| | //Substrate// | //Substrate// | //Substrate// | //Substrate// | //Substrate// | //Substrate// | //Substrate// | //Substrate// | //Substrate// | //Substrate// | //Substrate// |
| Number of layers | Film thickness (nm) | | | | | | | | | | |
| 9 | | | | | 1 | | | 1 | | | |
| 8 | | | 1 | 1 | 10 | 1 | 1 | 10 | | | |
| 7 | 3 | 3 | 88.2 | 86.1 | 79.4 | 88.5 | 86.4 | 79.1 | | | |
| 6 | 10 | 10 | 107.0 | 110.5 | 109.9 | 107.0 | 110.5 | 109.9 | 1 | 1 | 1 |
| 5 | 74.4 | 75. 2 | 33.8 | 34.8 | 32. 6 | 33.8 | 34.8 | 32.6 | 86.2 | 86.2 | 86.4 |
| 4 | 128.3 | 128.3 | 16.7 | 16.2 | 19.1 | 16.7 | 16.2 | 19.1 | 130.1 | 130.1 | 130.1 |
| 3 | 35. 7 | 35. 7 | 113.3 | 118.0 | 114.7 | 113.3 | 118.0 | 114.7 | 29.4 | 29.4 | 29.4 |
| 2 | 23.2 | 23.2 | 10.7 | 10.8 | 9.9 | 10.7 | 10.8 | 9.9 | 26.4 | 26.4 | 26.4 |
| 1 | 39.8 | 39. 8 | 29.3 | 32.3 | 33.6 | 29.3 | 32.3 | 33.6 | 24.9 | 24. 9 | 24.9 |
| Salt spray | ○ | ○ | ○ | ○ | ○ | ○ | ○ | ○ | ○ | ○ | ○ |
| Photocata lytic effect | Absent | Absent | Present | Present | Present | Present | Present | Present | Absent | Absent | Absent |

**Table III**

| No. | Example 22 | Example 23 | Example 24 | Example 25 | Example 26 | Example 27 |
|---|---|---|---|---|---|---|
| Number of layers | | Air | Air | Air | Air | |
| 8 | | A material | A material | B material | B material | |
| 7 | Air | SiO₂ | SiO₂ | SiO₂ | SiO₂ | Air |
| 6 | B 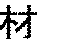 | TiO₂(IAD) | TiO₂(IAD) | TiO₂(IAD) | TiO₂(IAD) | A material |
| 5 | SiO₂ (IAD) | SiO₂(IAD) | SiO₂(IAD) | SiO₂(IAD) | SiO₂(IAD) | SiO₂+AL₂O₃(IAD) |
| 4 | Ta₂O₅(IAD) | Ta₂O₅(IAD) | Ta₂O₅(IAD) | Ta₂O₅(IAD) | Ta₂O₅(IAD) | Ta₂O₅(IAD) |
| 3 | SiO₂(IAD) | SiO₂(IAD) | SiO₂(IAD) | SiO₂(IAD) | SiO₂ (IAD) | Si O₂+AL₂O₃ (IAD) |
| 2 | Ta₂O₅(IAD) | Ta₂O₅ (I AD) | Ta₂O₅(IAD) | Ta₂O₅ (I AD) | Ta₂O₅(IAD) | Ta₂O₅(IAD) |
| 1 | SiO₂(IAD) | SiO₂(IAD) | SiO₂(IAD) | SiO₂(IAD) | SiO₂(IAD) | SiO₂+AL₂O₃(IAD) |
| | //Substrate// | //Substrate// | //Substrate// | //Substrate// | //Substrate// | //Substrate// |
| Number of layers | Film thickness (nm) | | | | | |
| 8 | | 1 | 1 | 1 | 1 | |
| 7 | | 86.4 | 86.4 | 86.4 | 86.4 | |
| 6 | 1 | 110.5 | 110.5 | 110.5 | 110.5 | 10 |
| 5 | 86.4 | 34.8 | 34.8 | 34.8 | 34.8 | 74.6 |
| 4 | 130.1 | 16.2 | 16.2 | 16.2 | 16.2 | 130.1 |
| 3 | 29.4 | 118.0 | 118.0 | 118.0 | 118.0 | 29.4 |
| 2 | 26.4 | 10.8 | 10.8 | 10.8 | 10.8 | 26.4 |
| 1 | 24.9 | 32.3 | 32.3 | 32.3 | 32.3 | 24.9 |
| Salt spray | ○ | ○ | ○ | ○ | ○ | ○ |
| Photocata lytic effect | Absent | Present | Present | Present | Present | Absent |

**Table IV**

| No. | Comparative example 1 | Comparative example 2 | Comparative example 3 | Comparative example 4 | Comparative example 5 | Comparative example 6 |
|---|---|---|---|---|---|---|
| Number of layers | | | | | | Air |
| 8 | | | | Air | Air | SiO₂ |
| 7 | | | Air | MgF₂ | SiO₂ | MgF₂ |
| 6 | Air | Air | SiO₂(IAD) | TiO₂(IAD) | TiO₂(IAD) | TiO₂(IAD) |
| 5 | SiO₂(IAD) | MgF₂ | MgF₂ | SiO₂(IAD) | SiO₂(IAD) | SiO₂(IAD) |
| 4 | Ta₂O₅(IAD) | Ta₂O₅(IAD) | Ta₂O₅(IAD) | Ta₂O₅(IAD) | Ta₂O₅(IAD) | Ta₂O₅(IAD) |
| 3 | SiO₂(IAD) | SiO₂(IAD) | SiO₂(IAD) | SiO₂(IAD) | SiO₂(IAD) | SiO₂(IAD) |
| 2 | Ta₂O₅(IAD) | Ta₂O₅ (IAD) | Ta₂O₅ (I AD) | Ta₂O₅(IAD) | Ta₂O₅(IAD) | Ta₂O₅(IAD) |
| 1 | SiO₂(IAD) | SiO₂(IAD) | SiO₂(IAD) | SiO₂(IAD) | SiO₂(IAD) | SiO₂(IAD) |
| | //Substrate// | //Substrate// | //Substrate// | //Substrate// | //Substrate// | //Substrate// |
| Number of layers | Film thickness (nm) | | | | | |
| 8 | | | | | | 10 |
| 7 | | | | 89.8 | 87.5 | 80.4 |
| 6 | | | 10 | 107.0 | 110.5 | 109.9 |
| 5 | 87.5 | 91.5 | 79.1 | 33.8 | 34.8 | 32.6 |
| 4 | 130.1 | 128.3 | 128.3 | 16.7 | 16.2 | 19.1 |
| 3 | 29.4 | 35.5 | 35.7 | 113.3 | 118.0 | 114.7 |
| 2 | 26.4 | 23.2 | 23.2 | 10.7 | 10.8 | 9.9 |
| 1 | 24.9 | 39.8 | 39.8 | 29.3 | 32.3 | 33.6 |
| Salt spray | × | × | × | × | × | × |
| Photocatalytic effect | Absent | Absent | Absent | Present | Present | Present |

**Table V**

| Sample No. | Target | | | | | Ion irradiation time (min) | Film thickness (nm) | Film forming rate (pm/sec) | Product | Element ratio contained in uppermost layer (at%) | | | | | | |
|---|---|---|---|---|---|---|---|---|---|---|---|---|---|---|---|---|
| | Kind | 1 | 2 | H (mm) | Φ (mm) | | | | | | | | | | | |
| Example 1 | A | SUS304 | | 125 | 285 | 165 | 15 | 1.52 | Si+Cr+Ni+Fe | Si | Fe | Ni | Cr | O | Others | Total |
| | | | SiO₂ (quartz) | 119 | 50 | | | | | 15.2 | 0.3 | 0.1 | 1.7 | 33.3 | 49.5 | 100.0 |
| Example 2, 27 | A | SUS304 | | 125 | 285 | 110 | 10 | 1.52 | Si+Cr+Ni+Fe | Si | Fe | Ni | Cr | 0 | Others | Total |
| | | | SiO₂ (quartz) | 119 | 50 | | | | | 15.2 | 0.3 | 0.1 | 1.7 | 33.3 | 49.5 | 100.0 |
| Example 3 | A | SUS304 | | 125 | 285 | 55 | 5 | 1.52 | Si+Cr+Ni+Fe | Si | Fe | Ni | Cr | 0 | Others | Total |
| | | | SiO₂ (quartz) | 119 | 50 | | | | | 15.2 | 0.3 | 0.1 | 1.7 | 33.3 | 49.5 | 100.0 |
| Example 4, 13, 14, 15 | A | SUS304 | | 125 | 285 | 11 | 1 | 1.52 | Si+Cr+Ni+Fe | Si | Fe | Ni | Cr | 0 | Others | Total |
| | | | SiO₂ (quartz) | 119 | 50 | | | | | 15.2 | 0.3 | 0.1 | 1.7 | 33.3 | 49.5 | 100.0 |
| Example 9, 11 | A | SUS304 | | 125 | 285 | 33 | 3 | 1.52 | Si+Cr+Ni+Fe | Si | Fe | Ni | Cr | O | Others | Total |
| | | | SiO₂ (quartz) | 119 | 50 | | | | | 15.2 | 0.3 | 0.1 | 1.7 | 33.3 | 49.5 | 100.0 |
| Example 19, 23 | A | SUS304 | | 125 | 285 | 11 | 1 | 1.52 | Si+Cr+Ni+Fe | Si | Fe | Ni | Cr | O | Others | Total |
| | | | SiO₂ (quartz) | 119 | 40 | | | | | 8.8 | 0.4 | 0.1 | 2.3 | 21.7 | 66.7 | 100.0 |

**Table VI**

| Sample No. | Target | | | | | Ion irradiation time (min) | Film thickness (nm) | Film forming rate (pm/sec) | Product | Element ratio contained in uppermost layer (at%) | | | | | | |
|---|---|---|---|---|---|---|---|---|---|---|---|---|---|---|---|---|
| | Kind | 1 | 2 | H (mm) | Φ (mm) | | | | | | | | | | | |
| Example 20, 24 | A | SUS304 | | 125 | 285 | 11 | 1 | 1.52 | Si+Cr+Ni+Fe | Si | Fe | Ni | Cr | O | Others | Total |
| | | | SiO₂ (quartz) | 119 | 60 | | | | | 30.6 | 0.0 | 0.0 | 0.3 | 61.6 | 7.5 | 100.0 |
| Example 5 | B | Ti | | 125 | 285 | 150 | 15 | 1.67 | Si+Ti | Si | Ti | O | - | - | Others | Total |
| | | | SiO₂ (quartz) | 119 | 50 | | | | | 17.1 | 0.6 | 35.2 | - | - | 47. 1 | 100.0 |
| Example 6 | B | Ti | | 125 | 285 | 110 | 11 | 1.67 | Si+Ti | Si | Ti | O | - | - | Others | Total |
| | | | SiO₂ (quartz) | 119 | 50 | | | | | 17.1 | 0.6 | 35.2 | - | - | 47.1 | 100.0 |
| Example 7 | B | Ti | | 125 | 285 | 50 | 5 | 1.67 | Si+Ti | Si | Ti | O | - | - | Others | Total |
| | | | SiO₂ (quartz) | 119 | 50 | | | | | 17.1 | 0.6 | 35.2 | - | - | 47.1 | 100.0 |
| Example 8, 16. 17, 18 | B | Ti | | 125 | 285 | 10 | 1 | 1.67 | Si+Ti | Si | Ti | O | - | - | Others | Total |
| | | | SiO₂ (quartz) | 119 | 50 | | | | | 17.1 | 0.6 | 35.2 | - | - | 47.1 | 100.0 |
| Example 10. 12 | B | Ti | | 125 | 285 | 30 | 3 | 1.67 | Si+Ti | Si | Ti | O | - | - | Others | Total |
| | | | SiO₂ (quartz) | 119 | 50 | | | | | 17.1 | 0.6 | 35.2 | - | - | 47. 1 | 100.0 |

**Table VII**

| Sample No. | Target | | | | | Ion irradiation time (min) | Film thickness (nm) | Film forming rate (pm/sec) | Product | Element ratio contained in uppermost layer (at%) | | | | | | |
|---|---|---|---|---|---|---|---|---|---|---|---|---|---|---|---|---|
| | Kind | 1 | 2 | H (mm) | Φ (mm) | | | | | | | | | | | |
| Example 21, 25 | B | Ti | | 125 | 285 | 10 | 1 | 1.67 | Si+Ti | Si | Ti | O | - | - | Others | Total |
| | | | SiO₂ (quartz) | 119 | 20 | | | | | 9.7 | 0.8 | 20.9 | - | - | 68.6 | 100.0 |
| Example 22, 26 | B | Ti | | 125 | 285 | 10 | 1 | 1.67 | Si+Ti | Si | Ti | O | - | - | Others | Total |
| | | | SiO₂ (quartz) | 119 | 80 | | | | | 26.8 | 0.2 | 53.9 | - | - | 19.1 | 100.0 |

The following was found from Tables I to WII. Examples 1 to 27, which are optical member samples having the constitution of the present invention, were prepared by adding any element of Cr or Ti to the uppermost layer containing SIO₂ as a main component as compared to Comparative Examples 1 to 6. By this constitution, Examples 1 to 27 were found to have excellent salt water resistance, no influence on spectral reflectance of the lower layer over time.

Moreover, it was found that the optical member sample which is provided with a TiO₂ containing layer in the optical member as a photocatalyst layer exhibited the photocatalytic effect, and had a self-cleaning function.

## Claims

1. An optical member comprising dielectric multilayer films on a substrate,
wherein an immediately lower layer of an uppermost layer is a layer containing any one of SiO₂, MgF₂ and Al₂O₃, or a mixture of any combination of SiO₂, MgF₂ and Al₂O₃; and
the uppermost layer is a metal oxide layer containing SiO₂ as a main component and also containing at least one of Cr and Ti.

2. The optical member described in claim 1,
wherein a content of Cr contained in the uppermost layer is in the range of more than 0.3 at% and less than 2.3 at%.

3. The optical member described in claim 1,
wherein a content of Ti contained in the uppermost layer is in the range of more than 0.2 at% and less than 0.8 at%.

4. The optical member described in any one of claims 1 to 3,
wherein a content of Si contained in the uppermost layer is in the range of more than 9 at% and less than 31 at%.

5. The optical member described in any one of claims 1 to 4,
wherein the uppermost layer has a thickness of 150nm or less.

6. The optical member described in any one of claims 1 to 5,
wherein the uppermost layer has a refractive index of 1.6 or less with respect to the light wavelength of 587.56 nm.

7. The optical member described in any one of claims 1 to 6, further having a layer containing TiO₂ on a lower layer side of the immediately lower layer of the uppermost layer.

8. The optical member described in any one of claims 1 to 7,
having an average spectral reflectance of 2% or less with respect to an incidence light from a normal direction in the light wavelength range of 420 to 680 nm.

9. A method of producing the optical member described in any one of claims 1 to 8, the method comprising the step of:
forming the uppermost layer using an ion source of an ion assisted deposition method as a sputtering source.
